Europäisches Patentamt

(19) European Patent Office

Office européen des brevets

(11) Numéro de publication: **0 037 544**
**B1**

(12) **FASCICULE DE BREVET EUROPEEN**

(45) Date de publication du fascicule du brevet: 10.10.84

(51) Int. Cl.³: **H 01 B 12/00, H 01 F 7/22**

(21) Numéro de dépôt: 81102385.2

(22) Date de dépôt: 30.03.81

(54) **Conducteur supraconducteur multibrins plat avec séparateur.**

(30) Priorité: 04.04.80 FR 8007682

(43) Date de publication de la demande:
14.10.81 Bulletin 81/41

(45) Mention de la délivrance du brevet:
10.10.84 Bulletin 84/41

(84) Etats contractants désignés:
BE CH DE FR GB IT LI LU NL SE

(56) Documents cités:
AT-A- 314 646
FR-A-2 142 694
FR-A-2 220 852

ADVANCES IN CRYOGENIC ENGINEERING,
vol. 23, aou7t 1977 New York, US Londres, GB
S.T. WANG et al. "Design and development of
crystable super-conducting ohmic heating
coils for a Tokamak", pages 255-264

(73) Titulaire: ALSTHOM-ATLANTIQUE Société
anonyme dite:
38, Avenue Kléber
F-75784 Paris Cedex 16 (FR)
(73) Titulaire: ELECTRICITE DE FRANCE Service
National
2, rue Louis Murat
F-75008 Paris (FR)

(72) Inventeur: Kiblaire, Michel
46, rue André Parant
F-90000 Belfort (FR)
Inventeur: Nithart, Henri
12, Bd. Renaud de Bourgogne
F-90000 Belfort (FR)
Inventeur: Fevrier, Alain
25, rue de Parisis
F-78310 Maurepas (FR)
Inventeur: Maldy, Jacques
3, Chemin de la Butte Le Val Saint Germain
F-91530 Saint Cheron (FR)

(74) Mandataire: Weinmiller, Jürgen et al
Zeppelinstrasse 63
D-8000 München 80 (DE)

Courier Press, Leamington Spa, England.

**Description**

La présente invention concerne un conducteur supraconducteur multibrins plat avec séparateur.

Les conducteurs supraconducteurs multibrins utilisés dans des bobines ou dans des alternateurs "cryoalternateurs" sont souvent réalisés sous forme de rubans plats, à la surface desquels les brins supraconducteurs apparaissent torsadés, notamment dans le but de réaliser une transposition, de sorte que les brins forment constamment deux nappes, chaque brin passant alternativement d'une nappe à l'autre sur le bord du ruban. En présence des tensions induites par des champs magnétiques variables, les courts-circuits dont le risque est alors le plus dangereux sont ceux qui pourraient se former entre les deux nappes aux croisements des brins.

Une première nécessité apparait alors: celle de disposer entre les deux nappes, un "séparateur" en forme de ruban, dont la surface au moins est isolante. Il est en effet connu que seule la présence d'un tel séparateur permet d'éviter, de manière pratique, les courts-circuits entre nappes. (Doir le document FR—A— 2 142 694.)

Une deuxième nécessité apparaît dans de nombreux cas: celle de détecter rapidement les transitions faisant passer localement un brin de l'état supraconducteur à l'état normal, de manière à réaliser alors une commutation évitant qu'une telle transition ne s'étende le long du conducteur et n'aboutisse finalement à la destruction de ce dernier par échauffement excessif. De telles transitions sont détectées par la tension d'origine résistive qu'elles font apparaître aux bornes du conducteur. Mais cette tension résistive peut être masquée par les tensions beaucoup plus importantes qui sont induites sur la longueur du conducteur par les champs magnétiques variables. Pour détecter la tension résistive, il est donc nécessaire d'éliminer la tension induite. Dans le cas d'une bobine, il est connu pour cela de prévoir sur celle-ci un point milieu, et de mettre en opposition les tensions totales apparaissant dans les deux moitiés de la bobine, de sorte que les tensions induites se compensent alors que la tension résistive résultant d'une transition locale accidentelle, n'apparaît normalement qu'aux bornes d'une seule des moitiés de la bobine, et peut donc être détectée. Cette solution n'est pas pratiquement applicable aux bobinages d'un alternateur.

Une autre solution connue consiste à adjoindre au conducteur supraconducteur "principal", sur toute sa longueur, une ligne conductrice "détectrice" disposée au contact de celui-ci avec interposition d'une couche isolante. Dans cette ligne, qui est laissée en circuit ouvert, sont induites les mêmes tensions que dans le conducteur principal. Pour faire apparaître la tension résistive il suffit alors de soustraire la tension induite dans cette ligne, de la tension totale, résistive et induite, apparaîssant dans le conducteur principal. Mais cette solution présente l'inconvénient de compliquer la mise en oeuvre du conducteur.

La présente invention a pour but la réalisation d'un conducteur supraconducteur multibrins plat avec séparateur, dont la mise en oeuvre est simple et qui permet une bonne détection des transitions éventuelles, même dans le cas où il est appliqué à la constitution du bobinage d'un alternateur.

Elle a pour objet un conducteur supraconducteur multibrins plat avec séparateur comportant:

— un séparateur isolant en forme de ruban avec une longueur selon un axe OX, une largeur selon un axe OY, et une épaisseur selon un axe OZ,

— des brins supraconducteurs inclinés sur l'axe OX, entourant ce séparateur de manière à constituer un assemblage conducteur à brins multiples conduisant globalement le courant selon l'axe OX, en deux nappes disposées sur les deux faces du séparateur, et séparées par celui-ci, la tension totale aux bornes de cet assemblage étant la somme de la tension induite par des champs magnétiques variables, et de la tension résistive résultant d'éventuelles transitions des brins de l'état supraconducteur à l'état normal,

— une ligne détectrice s'étendant tout au long du conducteur, en recueillant ainsi entre ses bornes la même dite tension induite, de manière à permettre de détecter lesdites transitions, en soustrayant cette tension induite de la tension dite totale,

caractérisé par le fait que cette ligne détectrice est constituée par une âme au moins partiellement métallique, qui est entourée d'une couche isolante et qui, avec cette couche isolante, constitue ledit séparateur,

— les éléments métalliques de cette âme étant disposés de manière à la rendre aisément déformable par flexion, non seulement dans le plan OX, OZ, mais aussi le plan OX, OY, pour éviter une désagrégation du conducteur lorsqu'on courbe celui-ci dans plusieurs plans,

— les éléments métalliques de l'âme étant inclinés dans un sens et dans l'autre par rapport à l'axe OX, de manière à conférer à tout trajet suivant une succession de ces éléments, une longueur supérieure d'au moins 10% à celle du conducteur, de manière à faciliter sa flexion.

A l'aide des figures schématiques ci-jointes, on va décrire ci-après, à titre non limitatif, comment l'invention peut être mise en oeuvre. Il doit être compris que les éléments décrits et représentés peuvent, sans sortir du cadre de l'invention, être remplacés par d'autres éléments assurant les mêmes fonctions techniques. Lorsqu'un même élément est représenté sur plusieurs figures il y est désigné par le même signe de référence.

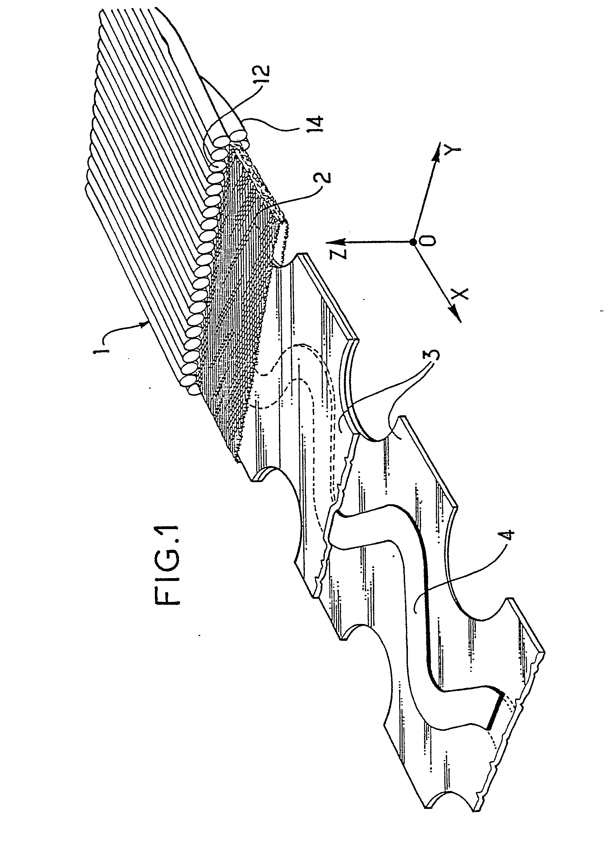

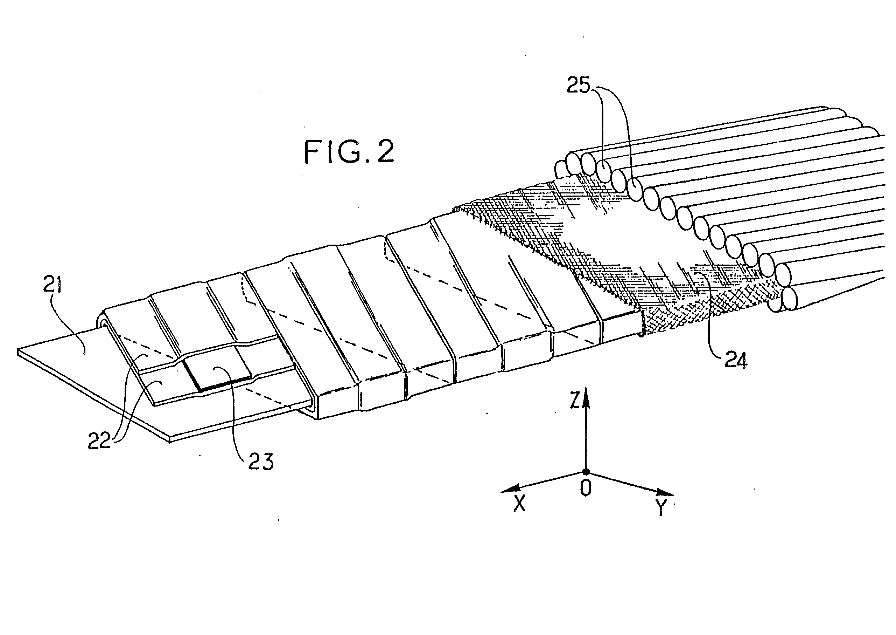

Les figures 1 et 2 représentent des vues d'un premier et d'un deuxième modes de réalisation du conducteur selon l'invention, respectivement, en perspective arrachée.

Sur la figure 1, les brins supraconducteurs sont représentés en 1. Ils sont par exemple au nombre de 23, avec un diamètre de 0,7 mm, et forment deux nappes à brins jointifs, chaque brin passant alternativement de la nappe supérieure 12 à la nappe inférieure 14, en traversant à chaque fois toute la largeur de la nappe, de manière à réaliser une transposition de type connu.

Les deux nappes sont séparées par un séparateur constitué par une tresse isolante tubulaire 2 aplatie, avec une largeur de 7 mm et une épaisseur de 0,4 mm à l'état pressé. Cette tresse peut être par exemple constituée de fils de polyamide aromatique vendu sous la désignation commerciale Nomex par la Société Dupont de Nemours.

Dans cette tresse sont disposées, sur toute la largeur intérieure de celle-ci, deux couches de polyimide 3, vendu sous le nom commercial "Kapton" par la société Dupont de Nemours, et constituant un excellent isolant électrique. Chacune de ces couches est par exemple épaisse de 25 microns.

Entre ces deux couches est disposé un ruban onduleux constitué de cuivre avec une épaisseur de 0,05 à 0,1 mm et une largeur de 1 mm environ. Ce ruban onduleux constitue ladite âme au moins partiellement métallique assurant la fonction de ligne détectrice. Les ondulations augmentent la flexibilité de cette âme dans le plan XOY. Elles peuvent avoir un pas de 5 mm et une amplitude de 1 mm, par exemple. Pour augmenter encore la flexibilité de l'âme, les bords latéraux des deux rubans isolants 3 sont découpés pour former des encoches en face des concavités des ondulations du ruban 4.

Dans le conducteur de la figure 2, les brins supraconducteurs 25 sont disposés comme les brins 1 de la figure 1. Mais le séparateur en forme de ruban est constitué par un enroulement aplati d'un ruban métallique 23 constituant ladite ligne détectrice et revêtu d'une couche isolante 22, 24. Ce ruban métallique a sa longueur et sa largeur disposée dans le plan OX, OY, et son épaisseur selon l'axe OZ. Il est disposé obliquement par rapport à l'axe OX, et plié sur les deux bords de ce séparateur, avec des lignes de pli parallèle à OX, de manière à être disposé alternativement sur l'une et sur l'autre face de ce séparateur avec des inclinaisons symétriques par rapport à cet axe.

La couche isolante 22, 24 est elle-même réalisée en deux éléments: le ruban métallique 23 est d'abord placé entre deux rubans isolants (polyimide) plus larges que lui et collés l'un à l'autre sur leurs deux bords, de part et d'autre du ruban 23 de manière à former tout autour de ce dernier, un premier enrobage isolant 22. Le ruban 22, 23 plus large ainsi obtenu est enroulé en hélice à plat, à spires jointives, autour d'un mandrin isolant 21, lui-même en forme de ruban, et l'ensemble est placé dans un deuxième enrobage isolant 24 constitué par une tresse analogue à la tresse 2.

Bien d'autres modes de réalisation du séparateur selon l'invention sont bien entendu possibles. Il peut par exemple être constitué par une tresse plate de fils isolants avec un ou plusieurs fils métalliques constituant la ligne détectrice, un enrobage isolant en forme de tresse ou de couche continue empêchant le contact entre ces fils métalliques et les brins supraconducteurs. Il peut aussi être réalisé autour d'un ruban métallique s'étendant selon la direction OX, sans ondulation ni pliage, mais avec des fentes s'étendant alternativement dans le sens OY à partir de ses deux bords pour lui conférer une flexibilité suffisante dans le plan XOY.

**Revendications**

1. Conducteur supraconducteur multibrins plat avec séparateur comportant:

— un séparateur isolant (2, 3, 4) en forme de ruban avec une longueur selon un axe OX, une largeur selon un axe OY et une épaisseur selon un axe OZ,

— des brins supraconducteurs (1) inclinés sur l'axe OX, entourant ce séparateur de manière à constituer un assemblage conducteur à brins multiples conduisant globalement le courant selon l'axe OX en deux nappes disposées sur les deux faces du séparateur et séparées par celui-ci, la tension totale aux bornes de cet assemblage étant la somme de la tension induite par des champs magnétiques variables et de la tension résistive résultant d'éventuelles transitions des brins de l'état supraconducteur à l'état normal,

— et une ligne détectrice (4) s'étendant tout au long du conducteur en recueillant ainsi entre ses bornes la même dite tension induite, de manière à permettre de détecter lesdites transitions en soustrayant cette tension induite de ladite tension totale,

— caractérisé par le fait que cette ligne détectrice est constituée par une âme au moins partiellement métallique (4) qui est entourée d'une couche isolante (3, 2) et qui, avec cette couche isolante, constitue ledit séparateur,

— les éléments métalliques de cette âme (4) étant disposés de manière à la rendre aisément déformable par flexion non seulement dans le plan OX, OZ, mais aussi dans le plan OX, OY pour éviter une désagrégation du conducteur lorsqu'on courbe celui-ci dans plusieurs plans,

— les éléments métalliques de ladite âme (4) étant inclinés dans un sens et dans l'autre par rapport à l'axe OX, de manière à conférer à tout trajet suivant une succession de ces éléments, une longueur supérieure d'au moins 10% à celle du conducteur, et à faciliter ainsi sa flexion dans son plan (OX, OY).

2. Conducteur selon la revendication 1, caractérisé par le fait que:

— ladite âme est métallique et présente la forme d'un ruban onduleux (4) avec des ondulations qui sont formées dans le plan OX, OY et conservant ce ruban dans ce plan, tant sur sa longueur que sur sa largeur, l'épaisseur de ce ruban étant disposée selon l'axe OZ,

— ce ruban onduleux étant disposé entre deux rubans isolants (3) superposés selon l'axe OZ, la longueur, la largeur et l'épaisseur de ces deux rubans isolants étant disposées selon les axes OX, OY et OZ respectivement, ces deux rubans isolants débordant des deux côtés de ce ruban onduleux.

3. Conducteur selon la revendication 2, caractérisé par le fait que les bords latéraux des deux rubans isolants (3) sont découpés pour former des encoches en face des concavités des ondulations du ruban onduleux (4).

4. Conducteur selon la revendication 1, caractérisé par le fait que ledit séparateur en forme de ruban est constitué par un enroulement aplati d'un ruban métallique (23) constituant ladite ligne détectrice et revêtu d'une couche isolante (22, 24), ce ruban métallique 23 ayant sa longueur et sa largeur disposées dans le plan OX, OY et son épaisseur selon l'axe OZ, et étant plié sur les deux bords de ce séparateur, avec des lignes de pli parallèle à OX, de manière à être disposé alternativement sur l'une et sur l'autre face de ce séparateur, avec des inclinaisons symétriques par rapport à cet axe.

## Patentansprüche

1. Supraleitender, viellitziger flacher Leiter, mit

— einem isolierenden Separator (2, 3, 4) in Form eines Bandes mit einer Länge entlang einer Achse OX, einer Breite entlang einer Achse OY und einer Dicke entlang einer Achse OZ,

— supraleitenden Litzen (1), die zur Achse OX geneigt sind und diesen Separator so umgeben, daß sie eine leitende Einheit mit vielen Litzen bilden, die den Strom global entlang der Achse OX in zwei Flächen auf den beiden Seiten des Separators und durch diesen getrennt leiten, wobei die Gesamtspannung an den Klemmen dieser Einheit die Summe der durch variable Magnetfelder induzierten Spannung und des aus eventuellen Übergängen der Litzen vom supraleitenden zum normalen Zustand entstehenden Spannungsabfalls ist,

— und einer Detektorleitung (4), die sich entlang des ganzen Leiters erstreckt und so zwischen ihren Klemmen dieselbe induzierte Spannung auffängt, so daß die Übergänge entdeckt werden können, indem man diese induzierte Spannung von der Gesamtspannung abzieht,

— dadurch gekennzeichnet, daß diese Detektorleitung aus einer mindestens teilweise metallischen Seele (4) besteht, die von einer Isolierschicht (3, 2) umgeben ist und die zusammen mit dieser Isolierschicht den Separator bildet,

— wobei die metallischen Elemente dieser Seele (4) so angeordnet sind, daß diese leicht durch Biegung verformt werden kann, und zwar nicht nur in der Ebene OX—OZ, sondern auch in der Ebene OX—OY, um zu vermeiden, daß der Leiter sich zerlegt, wenn man diesen in mehreren Ebenen krümmt,

— wobei die metallischen Elemente der Seele (4) in eine und die andere Richtung in bezug auf die Achse (OX) geneigt sind, so daß jeder Strecke entlang einer Folge dieser Elemente eine Länge, die um mehr als 10% die des Leiters übersteigt, verliehen und so seine Biegung in seiner Ebene (OX—OY) erleichtert wird.

2. Leiter nach Anspruch 1, dadurch gekennzeichnet, daß:

— die Seele metallisch ist und die Form eines gewellten Bandes (4) aufweist, dessen Wellen in der Ebene OX—OY ausgebildet sind und das Band in dieser Ebene halten, sowohl in seiner Länge als auch in seiner Breite, während die Dicke dieses Bandes gemäß der Achse OZ angeordnet ist,

— wobei dieses gewellte Band zwischen zwei Isolierbändern (3) liegt, die in Richtung der Achse OZ übereinanderliegen, und die Länge, die Breite und die Dicke dieser beiden Isolierbänder gemäß den Achsen OX, OY bzw. OZ angeordnet sind und diese beiden Isolierbänder auf beiden Seiten des gewellten Bandes überstehen.

3. Leiter nach Anspruch 2, dadurch gekennzeichnet, daß die Seitenränder der Isolierbänder (3) ausgeschnitten sind, um gegenüber den Vertiefungen des gewellten Bandes (4) Kerben zu bilden.

4. Leiter nach Anspruch 1, dadurch gekennzeichnet, daß der bandförmige Separator aus einer abgeflachten Aufwicklung eines Metallbands (23) besteht, das die Detektorleitung bildet und mit einer Isolierschicht (22, 24) bedeckt ist, wobei die Länge und die Breite dieses Metallbands (23) in der Ebene OX—OY und seine Dicke entlang der Achse OZ liegen und wobei dieses Metallband über die beiden Ränder dieses Separators umgebogen ist, mit Knicklinien, die parallel zu OX liegen, so daß es abwechselnd auf einer und der anderen Seite dieses Separators angeordnet ist, mit Neigungswinkeln, die in bezug auf diese Achse symmetrisch sind.

## Claims

1. A flat multi-strand superconducting conductor, including

— an insulating separator (2, 3, 4) in the form of a tape with its length along an axis OX, its width along an axis OY and its thickness along an axis OZ,

— superconductor strands (1) inclined relative to the axis OX and surrounding the separator so as to constitute a multi-strand conducting assembly which in the aggregate leads the current along the axis OX in two layers disposed on opposite side surfaces of the separator and separated by said insulating separator, the total voltage at the terminals of this assembly being the sum of the voltage induced by the variable magnetic fields and of the voltage drop which results from possible transitions of strands from the superconducting state to the normal state,

— and a detector line (4) which extends along the whole conductor, thus collecting between its terminals the same said induced voltage, so as to allow said transitions to be detected by subtracting this induced voltage from said total voltage,

— characterized in that said detector line is constituted by a core (4) which is at least partially made of metal and surrounded by an insulating layer (3, 2), which core, with said insulating layer, constitutes said separator,

— the metal components of said core (4) being disposed so as to make said core easily deformable by bending in the plane OX—OZ, and also in the plane OX—OY, to avoid disintegration of the conductor when it is curved in several planes,

— the metal components of said core (4) being inclined in one direction and in the other relative to the axis OX so that the length of any path along a succession of these components is at least 10% longer than that of the conductor and so as thus to facilitate bending of the conductor in its plane (OX—OY).

2. A conductor according to claim 1, characterized in that

— said core is a metal core and is in the form of a corrugated tape (4) whose corrugations lie in the plane OX—OY and maintain said tape in said plane as far as concerns both its length and its width, the thickness of said tape being disposed along the axis OZ,

— said corrugated tape being disposed between two insulating tapes (3) superposed along the axis OZ, the length, the width and the thickness of said two insulating tapes being disposed along the axes OX, OY and OZ respectively, with said two insulating tapes extending beyond the sides of said corrugated tape.

3. A conductor according to claim 2, characterized in that notches are cut in the side edges of the two insulating tapes (3), said notches facing concave portions of the corrugations in the corrugated tape (4).

4. A conductor according to claim 1, characterized in that said separator in the form of a tape is constituted by a flat winding of metal tape (23) which constitutes said detector line and is covered with an insulating layer (22, 24), this metal tape 23 having its length and its width disposed in the plane OX—OY and its thickness disposed along the axis OZ, and being folded over the two edges of said separator, the lines of the folds being parallel to OX, so as to be disposed alternately on opposed surfaces of said separator with inclinations which are symmetrical relative to this axis.

FIG.1

1

0 037 544

FIG.2